# FASCICULE DE BREVET EUROPEEN

(11) **EP 2 195 121 B1**
(45) Date de publication et mention de la délivrance du brevet: **23.02.2011**
(21) Numéro de dépôt: 08804378.1
(22) Date de dépôt: 18.09.2008
(51) Int. Cl.: B05D 5/12, C09D 5/44, H01B 1/12

(54) **PROCÉDÉ D'ÉLECTROGREFFAGE LOCALISÉ SUR DES SUBSTRATS SEMI-CONDUCTEURS PHOTOSENSIBLES**
VERFAHREN ZUM LOKALISIERTEN ELEKTROPFROPFEN AUF LICHTEMPFINDLICHE HALBLEITERSUBSTRATE
METHOD OF LOCALIZED ELECTROGRAFTING ONTO PHOTOSENSITIVE SEMICONDUCTOR SUBSTRATES

(30) Priorité: 20.09.2007 FR 0757723
(43) Date de publication de la demande: 16.06.2010
(73) Titulaire: Commissariat à l'Énergie Atomique et aux Énergies Alternatives, 75015 Paris (FR)
(72) Inventeur: CHARLIER, Julienne, F-91191 Gif-Sur-Yvette (FR); PALACIN, Serge, F-78180 Montigny Le Bretonneux (FR)
(74) Mandataire: Ilgart, Jean-Christophe
(86) Numéro de dépôt international: PCT/EP2008/062438
(87) Numéro de publication internationale: WO 2009/037311

(56) Documents cités:
- WO-A-2007/099137

## Description

### DOMAINE TECHNIQUE

La présente invention concerne le domaine des revêtements organiques de surface, lesdits revêtements étant sous la forme de films organiques. Elle est plus particulièrement relative à l'utilisation de solutions convenablement sélectionnées afin de permettre la formation simple et reproductible de films organiques par enduction sélective sur des surfaces semi-conductrices de l'électricité et particulièrement par électrogreffage. La présente invention concerne également un procédé de préparation de tels revêtements organiques.

### ÉTAT DE LA TECHNIQUE ANTÉRIEURE

A l'heure actuelle, il existe plusieurs techniques permettant la réalisation de films organiques minces sur des substrats, chacune reposant généralement sur une famille ou une classe de molécules adaptée.

Le procédé de formation d'un revêtement par centrifugation ou « spin coating » ne requiert pas d'affinité particulière entre les molécules déposées et le substrat d'intérêt, ce qui est également le cas des techniques apparentées de formation de revêtements par immersion (« dip coating ») ou de dépôt par vaporisation (« spray coating »). En effet, la cohésion du film déposé repose essentiellement sur les interactions entre les constituants du film qui peut, par exemple, être réticulé après dépôt pour en améliorer la stabilité. Ces techniques sont très versatiles, applicables à tout type de surface à couvrir, et très reproductibles. Cependant, elles ne permettent aucun greffage effectif entre le film et le substrat (il s'agit d'une simple physisorption). Les épaisseurs produites sont mal contrôlables notamment pour les dépôts les plus fins (inférieurs à 20 nanomètres) et rarement uniformes sur l'ensemble de la surface.

D'autres techniques de formation d'un revêtement organique à la surface d'un support, telles que le dépôt par plasma ou bien l'activation photochimique reposent sur un même principe : générer à proximité de la surface à couvrir des formes instables d'un précurseur, qui évoluent en formant un film sur le substrat. Si le dépôt par plasma ne requiert aucune propriété particulière de ses précurseurs, la photo-activation nécessite quant à elle l'utilisation de précurseurs photosensibles, dont la structure évolue sous irradiation lumineuse. Ces techniques donnent en général lieu à la formation de films adhérents, bien qu'il soit le plus souvent impossible de discerner si cette adhésion est due à une réticulation d'un film topologiquement fermé autour de l'objet ou à une réelle formation de liaisons à l'interface.

L'auto-assemblage de monocouches (SAM pour « Self Assembled Monolayers ») est une technique très simple à mettre en oeuvre qui requiert toutefois l'utilisation de précurseurs généralement moléculaires possédant une affinité suffisante pour la surface d'intérêt à revêtir. On parlera alors de couple précurseur-surface, tels les composés soufrés ayant une affinité pour l'or ou l'argent, les tri-halogéno silanes pour les oxydes comme la silice ou l'alumine, les polyaromatiques pour le graphite ou les nanotubes de carbone. Dans tous les cas, la formation du film repose sur une réaction chimique spécifique entre une partie du précurseur moléculaire (l'atome de soufre dans le cas des thiols par exemple) et certains sites « récepteurs » de la surface. Une réaction de chimisorption assure l'accrochage. Cependant, si les couples impliquant des surfaces d'oxyde peuvent donner lieu à la formation de films très solidement greffés (la liaison Si-O impliquée dans la chimisorption de tri-halogéno silanes sur silice est parmi les plus stables de la chimie), il n'en est rien lorsque l'on s'intéresse aux métaux ou aux semi-conducteurs sans oxyde.

L'électropolymérisation anodique consiste en la polymérisation d'espèces monomériques en présence d'électrons à proximité d'une surface conductrice ou semi-conductrice de l'électricité. La polymérisation conduit à la formation d'un film par précipitation au voisinage de la surface. Cependant, aucune liaison de nature covalente n'est créée entre la surface et le polymère, ceci a pour conséquence que les films obtenus ne présentent pas une résistance optimale aux agressions. Parmi les monomères utilisables selon cette technique, on peut notamment citer le pyrrole.

L'électrogreffage de polymères est une technique basée sur l'initiation puis la polymérisation, par propagation en chaîne, électro-induite de monomères électro-actifs sur la surface d'intérêt jouant à la fois le rôle d'électrode et celui d'amorceur de polymérisation. Il requiert l'utilisation de précurseurs adaptés à son mécanisme d'initiation par réduction et de propagation, en général anionique car on préfère souvent l'électrogreffage initié cathodiquement, applicable sur les métaux nobles et non nobles. L'électrogreffage par polarisation anodique n'est, quant à lui, applicable que sur des substrats nobles ou carbonés : graphite, carbone vitreux, diamant dopé bore. La demande internationale WO 03/018212 décrit notamment un procédé de greffage et de croissance d'un film organique conducteur sur une surface conductrice de l'électricité, le greffage et la croissance étant réalisés simultanément par électroréduction d'un sel de diazonium précurseur dudit film organique.

Parmi les différentes techniques rappelées précédemment, l'électrogreffage est la seule technique qui permette de produire des films greffés avec un contrôle spécifique de la liaison d'interface.

Les développements technologiques récents, liés à la course à la miniaturisation, ont entraîné l'émergence de procédés de revêtement plus perfectionnés permettant de localiser de manière spécifique le film organique sur une surface.

A ce titre, en référence à ce qui a été exposé plus haut, on peut notamment évoquer les travaux qui ont été réalisés sur les films organiques minces par la photolithographie. Cette technique repose principalement sur l'application d'un rayonnement lumineux sur une partie de la surface recouverte de la monocouche. Selon les modalités de mise en oeuvre le procédé peut conduire à une modification de la monocouche de manière localisée ou à sa disparition localisée par photocatalyse sur les liaisons chimiques.

L'électropolymérisation (Morgenstern et al., « Laser-assisted microstructuring and characterization of polythiophene », Sensors and Actuators A. 1995, vol. 51, p.103-107) permet, par l'application d'un rayonnement lumineux localisé, le dépôt de polymères organiques semi-conducteurs, comme le polythiophène, de manière précise sur des surfaces de silicium dopée n. Ces dépôts ne présentent cependant pas de liaisons d'interface définies avec leur substrat.

Malgré leur intérêt, les techniques, les plus perfectionnées des méthodes de revêtement de film localisé ne permettent pas de former des films organiques liés efficacement aux surfaces. En outre, à ce jour, aucun perfectionnement significatif n'a été apporté à l'électrogreffage dans ce domaine.

### EXPOSÉ DE L'INVENTION

La présente invention permet de résoudre les inconvénients des procédés et des revêtements de l'état de la technique et correspond notamment à un procédé de greffage localisé d'un film organique à la surface d'un substrat semi-conducteur, photosensible, en présence d'une solution électrolytique contenant un primaire d'adhésion organique et par application d'un potentiel électrique au substrat. Le greffage est réalisé sélectivement sur au moins une partie de la surface exposée à un rayonnement lumineux.

Plus précisément, l'invention correspond à un procédé de préparation d'un film organique sur une zone sélectionnée à la surface d'un substrat semi-conducteur photosensible, caractérisé en ce qu'il comprend les étapes suivantes :
i) mise en contact d'une solution liquide comprenant au moins un primaire d'adhésion organique avec au moins ladite zone sélectionnée ;
ii) polarisation de la surface dudit substrat à un potentiel électrique plus cathodique que le potentiel de réduction du primaire d'adhésion mis en oeuvre à l'étape (i) ;
iii) exposition de ladite zone sélectionnée à un rayonnement lumineux dont l'énergie est au moins égale à celle du gap dudit semi-conducteur.

Dans le cadre de la présente invention, on entend par « semi-conducteur », un matériau organique ou inorganique présentant une conductivité électrique intermédiaire entre les métaux et les isolants. Les propriétés de conductivité d'un semi-conducteur sont influencées principalement par les porteurs de charge (électrons ou trous) que présente le semi-conducteur. Ces propriétés sont déterminées par deux bandes d'énergie particulières appelées la bande de valence (correspondant aux électrons impliqués dans les liaisons covalentes) et la bande de conduction (correspondant aux électrons dans un état excité et capables de se déplacer dans le semi-conducteur). Le « gap » représente la différence d'énergie entre la bande de valence et la bande de conduction. Un semi-conducteur correspond également, à la différence des isolants ou des métaux, à un matériau dont la conductivité électrique peut être contrôlée, dans une large mesure, par ajout d'agents dopants qui correspondent à des éléments étrangers insérés dans la structure cristalline du semi-conducteur.

Dans le cadre de la présente invention, on entend par « semi-conducteur photosensible », un matériau semi-conducteur dont la conductivité peut être modulée par des variations de champ magnétique, de température ou d'illumination, qui influent sur les paires électrons-trous et la densité des porteurs de charge. Ces propriétés sont dues à l'existence du gap tel que défini précédemment. Ce gap n'excède généralement pas 3,5 eV pour les semi-conducteurs, contre 5 eV dans les matériaux considérés comme isolants. Il est donc possible de peupler la bande de conduction par excitation des porteurs au travers du gap, notamment sous illumination. Les éléments du groupe IV du tableau périodique, tels que le carbone (sous forme diamant), le silicium, le germanium présentent de telles propriétés. Des matériaux semi-conducteurs peuvent être formés de plusieurs éléments, tant du groupe IV, comme le SiGe ou le SiC, que du groupe III et V, comme GaAs, InP ou GaN, ou encore du groupe II et VI, comme CdTe ou ZnSe.

Avantageusement, dans le cadre de la présente invention, le substrat semi-conducteur photosensible est de nature inorganique. Ainsi, le semi-conducteur photosensible mis en oeuvre dans le cadre de la présente invention est choisi dans le groupe constitué par les éléments du groupe IV (plus particulièrement, le silicium et le germanium) ; les alliages d'éléments du groupe IV (plus particulièrement, les alliages SiGe et SiC) ; les alliages d'éléments du groupe III et du groupe V (appelés composés « III-V », tels que AsGa, InP, GaN) et les alliages d'éléments du groupe II et du groupe VI (appelés composés « II-VI », tels que CdSe, CdTe, Cu₂S, ZnS ou ZnSe). Le semi-conducteur photosensible préféré est le silicium.

Dans une variante de la présente invention, il est possible que le semi-conducteur photosensible soit dopé par un (ou plusieurs) agent(s) dopant(s). L'agent dopant est choisi en fonction du semi-conducteur, et le dopage est de type p ou n. Le choix de l'agent dopant et les technologies de dopage sont des techniques de routine pour l'homme du métier. De façon plus particulière, l'agent dopant est choisi dans le groupe constitué par le bore, l'azote, le phosphore, le nickel, le soufre, l'antimoine, l'arsenic et les mélanges de ceux-ci. A titre d'exemples, pour un substrat de silicium, parmi les agents dopants les plus employés de type p, on peut notamment citer le bore et, pour les dopants de type n, l'arsenic, le phosphore et l'antimoine.

Dans une autre variante, le substrat semi-conducteur est placé au contact et peut être en partie recouvert avec un matériau conducteur. Lorsque le substrat semi-conducteur est en partie recouvert avec un matériau conducteur, la partie de la surface recouverte n'est, de préférence, pas en contact avec la solution liquide. La partie du substrat au contact avec le matériau conducteur peut par exemple être située à proximité de la zone sélectionnée. Il est avantageux que la zone sélectionnée soit plane. Dans ce cas, la zone sélectionnée et la partie recouverte de matériau conducteur peuvent notamment être situées sur des surfaces sensiblement parallèles du substrat. De préférence, la partie recouverte de matériau est située sur la face arrière du substrat, la face « avant » du substrat correspondant à la face sur laquelle se situe la zone sélectionnée. Le matériau conducteur pourra être utilisé pour appliquer un potentiel électrique au substrat semi-conducteur photosensible d'intérêt. Tout matériau conducteur connu de l'homme du métier est utilisable dans le cadre de la présente invention. Toutefois, le matériau conducteur est généralement un métal tel que l'or.

Le terme « primaire d'adhésion » correspond, dans le cadre de la présente invention, à toute molécule organique susceptible, sous certaines conditions, de se chimisorber à la surface d'un support solide par réaction radicalaire, et notamment par électrogreffage, et comportant une fonction réactive vis-à-vis d'un autre radical après chimisorption.

Le primaire d'adhésion est avantageusement un sel d'aryle clivable choisi dans le groupe constitué par les sels d'aryle diazonium, les sels d'aryle d'ammonium, les sels d'aryle phosphonium et les sels d'aryle sulfonium. Dans ces sels, le groupe aryle est un groupe aryle qui peut être représenté par R tel que défini ci-après.

Parmi les sels d'aryle clivables, on peut en particulier citer les composés de formule (I) suivante :

R-N₂⁺, A⁻ (I)

dans laquelle :
- A représente un anion monovalent et
- R représente un groupe aryle.

A titre de groupe aryle des sels d'aryle clivables et notamment des composés de formule (I) ci-dessus, on peut avantageusement citer les structures carbonées aromatiques ou hétéroaromatiques, éventuellement mono- ou polysubstituées, constituées d'un ou plusieurs cycles aromatiques ou hétéroaromatiques comportant chacun de 3 à 8 atomes, le ou les hétéroatomes pouvant être N, O, P ou S. Le ou les substituants peuvent contenir un ou plusieurs hétéroatomes, tels que N, O, F, Cl, P, Si, Br ou S ainsi que des groupes alkyles en C₁ à C₆ notamment.

Au sein des sels d'aryle clivables et notamment des composés de formule (I) ci-dessus, R est de préférence choisi parmi les groupes aryles substitués par des groupements attracteurs d'électrons tels que NO₂, COH, les cétones, CN, CO₂H, NH₂, les esters et les halogènes. Les groupes R de type aryle particulièrement préférés sont les radicaux nitrophényle et phényle.

Au sein des composés de formule (I) ci-dessus, A peut notamment être choisi parmi les anions inorganiques tels que les halogénures comme I⁻, Br⁻ et Cl⁻, les halogénoborates tels que le tetrafluoroborate, et les anions organiques tels que les alcoolates, les carboxylates, les perchlorates et les sulfonates.

A titre de composés de formule (I), il est particulièrement avantageux d'utiliser un composé choisi dans le groupe constitué par le tétrafluoroborate de phényldiazonium, le tétrafluoroborate de 4-nitrophényldiazonium, le tétrafluoroborate de 4-bromophényldiazonium, le chlorure de 4-aminophényldiazonium, le chlorure de 2-méthyl-4-chlorophényldiazonium, le tétrafluoroborate de 4-benzoylbenzènediazonium, le tétrafluoroborate de 4-cyanophényldiazonium, le tétrafluoroborate du 4-carboxyphényldiazonium, le tétrafluoroborate de 4-acétamidophényldiazonium, le tétrafluoroborate de l'acide 4-phénylacétique diazonium, le sulfate de 2-méthyl-4-[(2-méthylphényl)diazényl]benzènediazonium, le chlorure de 9,10-dioxo-9,10-dihydro-1-anthracènediazonium, le tétrafluoroborate de 4-nitronaphtalènediazonium et le tétrafluoroborate de naphtalènediazonium.

La concentration en primaire dans la solution est variable et dépend du souhait de l'expérimentateur. Il est cependant recommandé de travailler à une concentration pour laquelle le primaire est entièrement soluble dans la solution liquide. Ainsi, par exemple, pour des sels d'aryle diazonium, la concentration sera typiquement comprise entre 10⁻³ et 5.10⁻² M

Avantageusement, dans le cas où le primaire d'adhésion est un sel d'aryle diazonium, le pH de la solution est inférieur à 7, typiquement inférieur ou égal à 3. Il est recommandé de travailler à un pH compris entre 0 et 3. Si nécessaire, le pH de la solution peut être ajusté à la valeur désirée à l'aide d'un ou plusieurs agents acidifiants bien connus de l'homme du métier, par exemple à l'aide d'acides minéraux ou organiques tels que l'acide chlorhydrique, l'acide sulfurique.

Le primaire d'adhésion peut soit être introduit en l'état dans la solution liquide telle que définie précédemment, soit être préparé *in situ* dans cette dernière. Ainsi, dans une forme de mise en oeuvre particulière, le procédé selon la présente invention comporte une étape de préparation du primaire d'adhésion, notamment lorsque celui-ci est un sel d'aryle diazonium. De tels composés sont généralement préparés à partir d'arylamine, pouvant comporter plusieurs substituants amine, par réaction avec NaNO₂ en milieu acide. Pour un exposé détaillé des modes expérimentaux utilisables pour une telle préparation *in situ*, l'homme du métier pourra se reporter à la littérature ouverte [D. Belanger et al. (2006) Chem. Mater. Vol. 18 ; 4755-4763]. De préférence, le greffage sera alors réalisé directement dans la solution de préparation du sel d'aryle diazonium.

La solution liquide contenant au moins un primaire d'adhésion mise en oeuvre dans le cadre de la présente invention peut en outre contenir au moins un monomère polymérisable par voie radicalaire différent dudit primaire d'adhésion.

Les monomères polymérisables par voie radicalaire mis en oeuvre dans le cadre de la présente invention correspondent aux monomères susceptibles de polymériser en condition radicalaire après amorçage par une entité chimique radicalaire. Typiquement, il s'agit de molécules comportant au moins une liaison de type éthylénique. Les monomères vinyliques, notamment les monomères décrits dans la demande de brevet FR 05 02516 ainsi que dans le brevet FR 03 11491, sont particulièrement concernés.

Selon une forme de réalisation particulièrement avantageuse de l'invention, le ou les monomères vinyliques sont choisis parmi les monomères de formule (II) suivante : 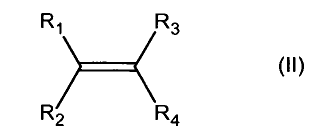 dans laquelle les groupes R₁ à R₄, identiques ou différents, représentent un atome monovalent non métallique tel qu'un atome d'halogène, un atome d'hydrogène, un groupe chimique saturé ou insaturé, tel qu'un groupe alkyle, aryle, un groupe -COOR₅ dans lequel R₅ représente un atome d'hydrogène ou un groupe alkyle en C₁-C₁₂ et de préférence en C₁-C₆, un nitrile, un carbonyle, une amine ou un amide.

Les composés de formule (II) ci-dessus sont en particulier choisis dans le groupe constitué par l'acétate de vinyle, l'acrylonitrile, le méthacrylonitrile, le méthacrylate de méthyle, le méthacrylate d'éthyle, le méthacrylate de butyle, le méthacrylate de propyle, le méthacrylate d'hydroxyéthyle, le méthacrylate d'hydroxypropyle, le méthacrylate de glycidyle et leurs dérivés ; les acrylamides et notamment les méthacrylamides d'amino-éthyle, propyle, butyle, pentyle et hexyle, les cyanoacrylates, les di-acrylates et di-méthacrylates, les tri-acrylates et tri-méthacrylates, les tétra-acrylates et tétra-méthacrylates (tels que le pentaérythritol tetraméthacrylate), le styrène et ses dérivés, le parachloro-styrène, le pentafluoro-styrène, la N-vinyl pyrrolidone, la 4-vinyl pyridine, la 2-vinyl pyridine, les halogénures de vinyle, d'acryloyle ou de méthacryloyle, le di-vinylbenzène (DVB), et plus généralement les agents réticulants vinyliques ou à base d'acrylate, de méthacrylate, et de leurs dérivés.

Selon un mode de réalisation particulier, les monomères employés sont ceux qui, *a contrario* des composés solubles en toute proportion dans la solution liquide considérée, sont solubles jusqu'à une certaine proportion dans la solution, i.e. la valeur de leur solubilité dans cette solution est finie. Les monomères utilisables conformément au procédé de l'invention peuvent ainsi être choisis parmi les composés dont la solubilité dans la solution liquide est finie et plus particulièrement inférieure à 0,1 M, plus préférentiellement entre 5.10⁻² et 10⁻⁶ M. Parmi de tels monomères, on peut par exemple citer le méthacrylate de butyle dont la solubilité, mesurée dans les conditions normales de température et de pression, est d'environ 4.10⁻² M. Selon l'invention, et sauf indication contraire, les conditions normales de pression et de température (CNTP) correspondent à une température de 25°C et à une pression de 1.10⁵ Pa.

L'invention s'applique également à un mélange de deux, trois, quatre ou plus monomères choisis parmi les monomères précédemment décrits.

La quantité de monomères polymérisables par voie radicalaire dans la solution liquide peut varier en fonction du souhait de l'expérimentateur. Cette quantité peut être supérieure à la solubilité du monomère considéré dans la solution liquide employée et peut représenter par exemple de 18 à 40 fois la solubilité dudit monomère dans la solution liquide à une température donnée, généralement la température ambiante ou celle de réaction. Dans ces conditions, il est avantageux d'employer des moyens permettant la dispersion des molécules de monomère dans la solution liquide tels qu'un tensioactif ou des ultrasons.

Selon un mode de réalisation particulier de l'invention, il est recommandé d'ajouter un tensioactif lorsque le monomère présente une solubilité inférieure à 5.10⁻² M. Une description précise des tensioactifs utilisables dans le cadre de l'invention est donnée dans la littérature (Deniau et al., Chem. Mater. 2006, 18, 5421-5428) auxquelles l'homme du métier pourra se référer. Un seul tensioactif ou un mélange de plusieurs tensioactifs peut être utilisé. La quantité de tensioactif(s) nécessaire est variable ; elle doit notamment être suffisante pour permettre la formation du film organique. La quantité minimale de tensioactif(s) peut être facilement déterminée en échantillonnant des solutions de composition identique mais de concentration variable en tensioactif(s). De manière générale, la concentration en tensioactif(s) est telle que la concentration micellaire critique (CMC) soit atteinte et qu'il puisse y avoir ainsi formation de micelles. La CMC d'un tensioactif peut être déterminée par les méthodes connues de l'homme du métier, par exemple par des mesures de tensions de surface. Typiquement la concentration en tensioactif sera comprise entre 0,5 mM et 5 M environ, de préférence entre 0,1 mM et 150 mM environ. La concentration recommandée en tensioactif est usuellement de 10 mM.

Les tensioactifs sont des molécules comportant une partie lipophile (apolaire) et une partie hydrophile (polaire). Parmi les tensioactifs utilisables selon l'Invention, on peut notamment citer :
i) les tensioactifs anioniques dont la partie hydrophile est chargée négativement ; de préférence le tensioactif sera un alkyle ou un aryle sulfonates, sulfates, phosphates, ou sulfosuccinates associé à un contre ion comme un ion ammonium (NH₄⁺), un ammonium quaternaire tel que tetrabutylammonium, et les cations alcalins tels que Na⁺, Li⁺ et K⁺ ;
ii) les tensioactifs cationiques dont la partie hydrophile est chargée positivement ; ils sont de préférence choisis parmi les ammoniums quaternaires comportant au moins une chaînes aliphatiques en C₄-C₂₂ associés à un contre ion anionique choisi notamment parmi les dérivés du bore tels que le tetrafluoroborate ou les ions halogénures tels que F⁻, Br⁻, I⁻ ou Cl⁻ ;
iii) les tensioactifs zwittérioniques qui sont des composés neutres possédant des charges électriques formelles d'une unité et de signe opposé ; ils sont de préférence choisis parmi les composés présentant une chaîne alkyle en C₅-C₂₀ substituée généralement par une fonction chargée négativement comme un sulfate ou un carboxylate et une fonction chargée positivement comme un ammonium ;
iv) les tensioactifs amphotères qui sont des composés se comportant à la fois comme un acide ou comme une base selon le milieu dans lequel ils sont placés ; ces composés peuvent avoir une nature zwittérionique, les acides aminés sont un exemple particulier de cette famille,
v) les tensioactifs neutres (i.e. non-ioniques) : les propriétés tensioactives, notamment l'hydrophilie, sont apportées par des groupements fonctionnels non chargés tels qu'un alcool, un éther, un ester ou encore une amide, contenant des hétéroatomes tels que l'azote ou l'oxygène ; en raison de la faible contribution hydrophile de ces fonctions, les composés tensioactifs non ioniques sont le plus souvent polyfonctionnels.

Les tensioactifs chargés peuvent bien entendu porter plusieurs charges.

A titre de tensioactif anionique, il est par exemple possible d'utiliser le paratoluènesulfonate de tetraéthylammonium, le dodécylsulfate de sodium, le palmitate de sodium, le stéarate de sodium, le myristate de sodium, le di(2-éthylhexyl) sulfosuccinate de sodium, le méthylbenzène sulfonate et l'éthylbenzène sulfonate.

A titre de tensioactif cationique, il est par exemple possible d'employer le chlorure tétrabutylammonium, le chlorure tetradécylammonium, le bromure de tetradécyltriméthyle ammonium (TTAB), les halogénures d'alkylpyridinium portant une chaîne aliphatique et les halogénures d'alkylammonium.

A titre de tensioactif zwittérionique, il est possible d'employer le N,N diméthyldodécylammoniumbutanate de sodium, le diméthyldodécylammonium propanate de sodium et les acides aminés.

A titre de tensioactif amphotère, il est possible d'utiliser le lauroamphodiacétate de disodium, les bétaïnes comme l'alkylamidopropylbétaïne ou la laurylhydroxysulfobétaïne.

A titre de tensioactif non-ionique, il est possible d'employer les polyéthers comme les tensioactifs polyéthoxylés tels que par exemple le lauryléther de polyéthylèneglycol (POE23 ou Brij ® 35), les polyols (tensioactifs dérivés de sucres) en particulier les alkylates de glucose tels que, par exemple, l'hexanate de glucose.

Parmi les tensioactifs préférés selon l'invention, on peut citer les tensioactifs anioniques tels que les sulfonates, les ammoniums quaternaires et les tensioactifs non ioniques tels que les polyoxyéthylènes.

Selon une autre modalité de réalisation de l'invention, il est possible d'employer des ultrasons pour favoriser la solubilisation du monomère ou pour former une dispersion lorsque le monomère est insoluble dans la solution liquide [R. Asami et al. Langmuir B, 2006, sous presse].

Selon les dispositions présentées, la solubilité du monomère s'avère ne pas être un obstacle à la réalisation du procédé grâce à l'utilisation de moyens techniques, tels qu'une agitation vigoureuse notamment induite par les ultrasons, qui permettent la formation d'une dispersion et/ou d'une émulsion, pour le ou les monomère(s) liquide(s). Dans le cas de monomère(s) polymérisable (s) ne présentant pas d'affinité pour la solution liquide employée, comme les monomères non hydrosolubles dans l'eau, il est donc avantageux que la solution se présente sous la forme d'une émulsion ou d'une dispersion.

Dans une variante, le procédé selon la présente invention comprend une étape préalable durant laquelle le monomère polymérisable ou le mélange de monomères polymérisables est dispersé ou émulsionné en présence d'au moins un tensioactif ou par action des ultrasons, avant son mélange à la solution liquide comprenant au moins un primaire d'adhésion.

Au sens de la présente invention, on entend par « film organique », tout film de nature organique, issu de plusieurs unités d'espèces chimiques organiques, lié de manière covalente à la surface du support sur lequel est mis en oeuvre le procédé objet de l'invention. Il s'agit particulièrement de films liés de manière covalente à la surface d'un support et comprenant au moins une couche d'unités structurales de nature similaires, selon l'épaisseur du film, sa cohésion étant assurée par les liaisons covalentes qui se développent entre les différentes unités.

Le film organique obtenu selon le procédé de l'invention peut être uniquement constitué d'unités dérivées du primaire d'adhésion, dans le cas où la solution liquide ne contient aucun autre élément capable de polymériser par voie radicalaire.

Lorsque la solution liquide contient, en plus du primaire d'adhésion, au moins un monomère polymérisable par voie radicalaire différent dudit primaire d'adhésion, le film organique obtenu selon le procédé de l'invention peut être également polymère ou copolymère, issu de plusieurs unités monomériques d'espèces chimiques identiques ou différentes et/ou de molécules de primaire d'adhésion. Les films obtenus par le procédé de la présente invention sont « essentiellement » du type polymère dans la mesure où le film incorpore également des espèces issues du primaire d'adhésion et pas uniquement des monomères présents. Un film organique dans ce mode particulier de réalisation est ainsi notamment un film préparé à partir d'au moins un type de primaire d'adhésion, ou d'au moins un type de monomère polymérisable, particulièrement par voie radicalaire, et d'au moins un type de primaire d'adhésion. Avantageusement, le film organique dans le cadre de l'invention présente une séquence en unités monomériques dans laquelle la première unité est constituée par un dérivé du primaire d'adhésion, les autres unités étant indifféremment dérivées des primaires d'adhésion et des monomères polymérisables.

La solution liquide contenant au moins un primaire d'adhésion mise en oeuvre dans le cadre de la présente invention peut en outre contenir un solvant. Ainsi, tout ce qui a été précédemment défini par rapport à la solution liquide (comme la solubilité du primaire d'adhésion et la solubilité du monomère) s'applique *mutatis mutandis* à la solution liquide contenant au moins un solvant. Il est préférable que le solvant employé soit un solvant protique. Par « solvant protique », on entend, dans le cadre de la présente invention, un solvant qui comporte au moins un atome d'hydrogène susceptible d'être libéré sous forme de proton.

Le solvant protique est avantageusement choisi dans le groupe constitué par l'eau, l'acide acétique, les solvants hydroxylés comme le méthanol et l'éthanol, les glycols liquides de faible poids moléculaire tels que l'éthylèneglycol, et leurs mélanges. Selon une forme de réalisation particulière de l'invention, un solvant protique pur peut être utilisé en mélange avec un solvant aprotique étant entendu que le mélange résultant présente les caractéristiques d'un solvant protique et sera à ce titre considéré comme tel.

La solution liquide contenant au moins un primaire d'adhésion mise en oeuvre dans le cadre de la présente invention peut en outre contenir au moins un électrolyte support. Ledit électrolyte support peut notamment être choisi parmi les sels d'ammoniums quaternaires tels que les perchlorates, les tosylates, les tetrafluoroborates, les hexafluorophosphates, les halogénures d'ammoniums quaternaires à chaine courte, le nitrate de sodium et le chlorure de sodium.

Parmi ces sels d'ammoniums quaternaires on peut en particulier citer à titre d'exemple le perchlorate de tetraéthylammonium (TEAP), le perchlorate de tetrabutylammonium (TBAP), le perchlorate de tetrapropylammonium (TPAP), le perchlorate de benzyltriméthylammonium (BTMAP).

Lors de l'étape (ii) du procédé de la présente invention, la polarisation est effectuée à un potentiel électrique plus cathodique que le potentiel de réduction du primaire d'adhésion utilisé. Selon l'invention, il est préférable que le potentiel employé à l'étape (ii) soit proche du potentiel de réduction du primaire d'adhésion mis en oeuvre et qui réagit en surface. Ainsi la valeur du potentiel utilisé lors de l'étape (ii) du procédé selon l'invention peut être jusqu'à 50% plus élevée que le potentiel de réduction du primaire d'adhésion, plus typiquement elle ne sera pas supérieure à 30%.

La polarisation de la surface peut être effectuée par toute technique connue de l'homme du métier et notamment en conditions de voltampérométrie linéaire ou cyclique, en conditions potentiostatiques, potentiodynamiques, intensiostatiques, galvanostatiques, galvanodynamiques ou par chronoampérométrie simple ou pulsée. Avantageusement, le procédé selon la présente invention est réalisé en conditions de voltampérométrie cyclique. Dans ce cas, le nombre de cycles sera compris, de manière préférentielle, entre 1 et 10 et, encore plus préférentiellement, entre 1 et 5. Selon l'invention, il est préférable que, lors d'un balayage de potentiel, le domaine de potentiel balayé soit compris entre le potentiel d'équilibre de la solution liquide telle que précédemment définie et entre une valeur supérieure au maximum à 50% de la valeur du potentiel de réduction du primaire, et typiquement pas plus de 30% supérieure à cette valeur.

Le procédé selon la présente invention peut ainsi notamment être réalisé dans une cellule d'électrolyse comportant trois électrodes : une première électrode de travail constituant la surface destinée à recevoir le film, une contre électrode ainsi qu'une électrode de référence.

Lors de l'étape (iii) du procédé selon la présente invention, le rayonnement lumineux est typiquement choisi de telle sorte que l'exposition du substrat audit rayonnement conduise à une augmentation de sa conductivité. Sa longueur d'onde devra donc être suffisamment faible, i.e. son énergie est au moins égale à celle du gap du semi-conducteur, pour que les porteurs de charge du substrat semi-conducteur puissent être excités vers la bande de conduction.

Il est préférable que le primaire d'adhésion et les monomères éventuellement présents conservent leur intégrité lorsqu'ils sont exposés au rayonnement lumineux. Aussi il est avantageux que leur absorbance pour les longueurs d'ondes correspondant à celles du rayonnement lumineux soit aussi faible que possible.

Le rayonnement employé peut être focalisé, par exemple à l'aide d'une lentille optique, sur la zone sélectionnée de la surface. Il est possible d'employer diverses sources de rayonnement. Le rayonnement peut être monochromatique ou polychromatique. Avantageusement, le rayonnement utilisé à l'étape (iii) du procédé selon l'invention est monochromatique filtré ou polychromatique filtré.

Typiquement l'intensité du rayonnement est au moins égale à 2 mW.cm⁻² et n'est pas supérieure à 45 mW.cm⁻². La longueur d'onde principale est adaptée en fonction du gap associé au semi-conducteur ; la valeur du gap pour un quelconque semi-conducteur dopé ou non est une valeur facilement accessible à l'homme du métier. Ainsi, par exemple, si le substrat est constitué de silicium, l'énergie du rayonnement doit être au moins égale à 1,12 eV (valeur du gap dans le cas du silicium) ce qui signifie que la longueur d'onde doit être inférieure ou égale à 1,1 µm (X. G. Zhang, Electrochemistry of silicon and its oxide, Kluwer Academic / Plenum Publishers, 2001). Ainsi, le rayonnement visible de type lumière blanche, issu, par exemple, d'une lampe halogène de 100 W peut être utilisé. La valeur du gap pour différents semi-conducteurs (CRC Handbook of Chemistry and Physics, David R. Lide Ed, CRC Press, Boca Raton) ainsi que différentes méthodes de mesures sont illustrés dans la liiérature (D. Gal et al. Journal of Applied Physics, 86, 10, 5573-5577).

Il est recommandé de filtrer la lumière blanche pour des longueurs d'onde auxquelles le primaire d'adhésion ou les éventuels monomères ne sont pas stables. Ainsi, par exemple, il est souhaitable de ne pas employer une longueur d'onde inférieure à 550 nm pour des sels d'aryle clivables. Typiquement, si le rayonnement est fourni par une source de lumière blanche, celle-ci est filtrée à 590 nm.

L'électrogreffage est réalisé de manière sélective sur la zone sélectionnée. Au sens de la présente invention, un greffage est dit « sélectif » lorsque le rapport entre la quantité de film greffé en condition sélective et entre la quantité de film greffée dans les conditions électrochimiques standards est supérieur à 1. Typiquement un tel rapport sera supérieur à 10 et plus généralement supérieur à 20.

Le temps d'exposition au rayonnement lumineux mis en oeuvre lors de l'étape (iii) du procédé de l'invention est fonction de la durée d'application du potentiel. Il est préférable que les étapes (ii) et (iii) soient réalisées simultanément. Il est ainsi recommandé d'exposer la surface au rayonnement lumineux pendant l'application du potentiel électrique, avantageusement durant un temps correspondant à celui de l'électroréduction. Ainsi, le temps d'exposition varie généralement d'une dizaine de secondes à une heure.

Selon un mode de réalisation particulier seule la zone sélectionnée de la surface du substrat est exposée à un rayonnement lumineux. Il est pour cela recommandé d'employer, à l'étape (iii) du procédé selon la présente invention, un masque, imperméable au rayonnement employé, en regard de la surface du substrat ou à proximité de celle-ci. Un tel masque correspond généralement à un élément extérieur placé pour occulter une partie du rayonnement lumineux. Les contours de la lumière du masque sont typiquement homothétiques aux contours de la zone de la surface qui a été sélectionnée.

Dans un mode de réalisation particulier, seule une partie de la surface du substrat est polarisée. Ce mode de réalisation peut être obtenu en utilisant un substrat semi-conducteur non-homogène présentant au moins une partie dopée et au moins une partie non-dopée. Typiquement l'utilisation d'agents dopants permet de modifier les propriétés locales du substrat et de ne polariser que la partie dopée. Dans ces conditions, le film organique sera obtenu seulement sur la partie polarisée et sélectivement sur une zone sélectionnée, exposée à un rayonnement, de ladite partie.

L'invention concerne également une surface susceptible d'être obtenue par le procédé selon la présente invention.

Les surfaces obtenues conformément à la présente invention peuvent être utilisées dans tout type d'industrie et notamment dans les industries de l'électronique et de la microélectronique (par exemple pour la préparation de composants microélectroniques), pour la préparation de dispositifs biomédicaux tels que par exemple des dispositifs implantables dans l'organisme (stents par exemple), des kits de criblages, etc.

L'invention est applicable par ailleurs à différentes échelles et aussi bien dans les systèmes technologiques électrochimiques de taille micro- et nanométrique (EMST pour « Electrochemical Micro- an Nano-System Technologies ») qu'à une échelle perceptible à l'oeil nu pour des revêtements de surface de différents types.

L'invention a également pour objet un procédé d'exaltation de l'électrogreffage de sels clivables d'aryle diazonium sur au moins une partie de la surface d'un semi-conducteur au contact d'une solution comprenant lesdits sels. Un tel procédé peut être mis en oeuvre selon les dispositions qui précèdent et peut notamment être réalisé par l'exposition d'une zone de la surface du substrat semi-conducteur sur laquelle le greffage doit être réalisé, à un rayonnement lumineux dont l'énergie est au moins égale à celle du gap du semi-conducteur.

D'autres caractéristiques et avantages de la présente invention apparaîtront encore à l'homme du métier à la lecture des exemples ci-dessous donnés à titre illustratif et non limitatif, et faisant référence aux figures annexées.

### BRÈVE DESCRIPTION DES DESSINS

La figure 1 représente une cellule d'électrolyse utilisable dans le cadre de l'invention.
La figure 2 correspond à un masque permettant d'exposer sélectivement une zone sélectionnée.
La figure 3 correspond à la surface d'un substrat dont une zone a été exposée sélectivement à un rayonnement lumineux grâce au masque représenté en figure 1.

### EXPOSÉ DÉTAILLÉ DE MODES DE RÉALISATION PARTICULIERS

### I. Matériel et Méthodes

### I.1. Plaquettes.

Les exemples présentés ci-après ont été réalisés à partir de plaques (wafer) de silicium obtenu auprès d'ACM (France). Ces plaques ont été nettoyées par un traitement aux solvants et à l'acide afin d'éliminer les éventuels polluants organiques présents sur les surfaces.

Des plaquettes rectangulaires de 5x30 mm ont été coupées à partir des plaques de silicium et employées dans le procédé. Trois types de plaquettes sont distingués en fonction du dopage de type p (avec du bore en particules par cm⁻³) qui est important (1,5.10¹⁸ cm⁻³, Si-p++), moyen (2,1.10¹⁷ cm⁻³, Si-p+) ou faible (1,5.10¹⁵ cm⁻³, Si-p).

Une couche d'or (placée sur sous-couche de chrome) a ensuite été évaporée sur la face arrière des plaquettes afin d'établir un contact électrique et d'assurer un contact ohmique (méthode eutectique avec une couche de InGa).

### I.2. Solution de primaire d'adhésion.

Afin de mettre en oeuvre le procédé selon l'invention, une solution de tétrafluoroborate de 4-nitrobenzène-diazonium a été préparée (2.10⁻³ M dans du H₂SO₄ à 0,2 M).

### I.3. Procédé selon l'invention.

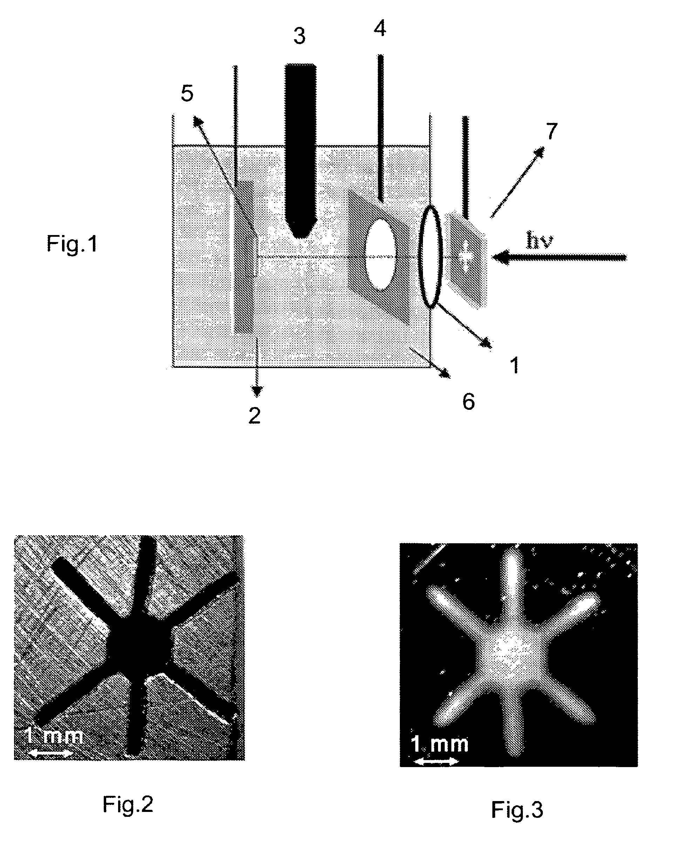

Le procédé a été mis en oeuvre dans une cellule d'électrolyse en polypropylène qui ne laisse pas passer la lumière blanche (figure 1), dont l'une des faces comportait une partie en verre (1) afin de laisser passer le rayonnement lumineux.

La surface des plaquettes en contact avec la solution a été délimitée par un film adhésif (2) et l'électrolyse réalisée à l'aide d'un dispositif standard à trois électrodes : une électrode de référence (3) (Hg⁺⁺/Hg, 10⁻² M HgSO₄ dans K₂SO₄ saturé), contre-électrode (4) (électrode de platine de 5 cm²) et électrode active (5) correspondant à la lamelle de silicium telle que préparée, dans laquelle la solution préparée (6) a été placée. Les valeurs de potentiel présentées ci-après sont données en fonction de l'électrode de référence (Hg/HgSO₄ - MSE).

Les irradiations ont été réalisées à l'aide d'une source polychromatique filtrée (lumière blanche) de telle sorte que la longueur d'onde soit > 590 nm, la puissance a été fixée à 3 mW.cm⁻² (Fiber Optic Illuminator 77501, Oriel). Afin de focaliser le rayonnement et de réduire la réflexion dans la cellule, une lentille optique a été ajoutée au dispositif.

Le potentiel a été appliqué à l'aide d'un potentiostat EG&G PAR (273A) par voltampérométrie (ou voltamétrie) linéaire cyclique. Des balayages en potentiel sur un domaine compris entre + 50% et - 50% par rapport au seuil de réduction du sel de diazonium ont été effectués. Plus précisément les balayages ont été effectués entre - 0,4 V, qui corrrespond à la valeur d'équilibre du système, et 1,2 V par rapport à la référence, le portentiel de réduction du diazonium étant situé à - 0,8 V par rapport à la référence.

### II. Résultats.

### II.1. Vérifications préalables.

### a. Vérifications du greffage.

La localisation des zones sur lesquelles un film organique a été greffé a été vérifiée par spectrophotométrie X (spectroscopie des photoélectrons X - XPS). Le nitrobenzène greffé présente des caractéristiques spectrales particulières (bande N 1s avec un pic caractéristique à 406 eV qui correspond au groupe nitro) qui peuvent être employées pour déterminer non seulement la présence d'un film organique mais également la croissance de celui-ci sur la surface.

### b. Non-altération du primaire d'adhésion et du film suite à l'exposition au rayonnement.

Dans un premier temps, il a été vérifié que le primaire d'adhésion n'était pas altéré lors de l'exposition au rayonnement utilisé. Des mesures d'absorbance ont permis de déterminer que, pour le rayonnement employé, la valeur de l'absorbance du sel de diazonium utilisé est asymptotiquement proche de zéro.

Il a été également vérifié qu'un film greffé par simple application d'un procédé électrochimique, ainsi que proposé par la demande internationale WO 03/018212, n'était pas altéré par l'exposition à ce rayonnement. Après une exposition de 2 h, le spectre XPS obtenu n'avait pas varié.

### c. Spécificité du greffage.

Afin d'obtenir des mesures plus fiables, il a été également vérifié que des lamelles, placées dans la solution, en absence de potentiel électrique, ne permettaient pas de greffer de manière conséquente un film organique tant en présence d'un rayonnement qu'en absence de rayonnement.

### II.2. Greffage du film sur plaquettes de silicium dopé.

Dans le tableau 1, sont résumés les résultats qui ont été obtenus pour les plaquettes de Si-p++ dans les différentes conditions i.e. en présence (rayonnement) et en absence de rayonnement (obscurité). La valeur attribuée à chacune des expériences correspond au pourcentage que représente la bande N 1s déterminée sur le spectre XPS.

**Tableau 1**

| Si-p++ | Obscurité (11h) | Rayonnement (5h) | Obscurité, voltampérométrie cyclique, 30 scans, 1h | Rayonnement, voltampérométrie cyclique, 30 scans, 1h |
|---|---|---|---|---|
| N 1s (XPS) | 0,3 | 0,1 | 0,3 | 6,7 |

Les résultats obtenus pour différentes plaquettes de silicium, en fonction du type de dopage sont présentés dans le tableau 2 ci-dessous.

**Tableau 2**

| | N 1s (XPS) |
|---|---|
| Si-p++ | 6,7 |
| Si-p+ | 7,0 |
| Si-p | 9,6 |

Il y a lieu d'observer que l'utilisation d'un rayonnement permet d'exalter l'électrogreffage puisqu'une nette augmentation de la bande N 1s est observée.

En outre, il est également possible de moduler l'exaltation en modifiant le dopage du substrat, les variations sont sensibles comme indiqué par les résultats du tableau 2. L'exaltation du greffage est telle que la quantité de film greffé est comprise entre 22 et 32 fois la quantité greffée dans les conditions standard.

Par ailleurs, le film obtenu sous illumination présente les mêmes caractéristiques spectroscopiques XPS que celui obtenu dans les mêmes conditions de potentiel dans le noir.

### II.3. Utilisation d'un masque.

Afin d'illustrer plus avant l'invention un masque (7) métallique, représenté schématiquement sur la figure 2, a été ajouté au dispositif précédemment employé.

Dans les conditions précitées, il a été possible de préparer un substrat recouvert d'un motif homothétique de la lumière du masque (figure 3).

## Revendications

1. Procédé de préparation d'un film organique sur une zone sélectionnée à la surface d'un substrat semi-conducteur photosensible éventuellement dopé par un (ou plusieurs) agent(s) dopant(s), **caractérisé en ce qu'**il comprend les étapes suivantes :
i) mise en contact d'une solution liquide comprenant au moins un primaire d'adhésion organique avec au moins ladite zone sélectionnée ;
ii) polarisation de la surface dudit substrat à un potentiel électrique plus cathodique que le potentiel de réduction du primaire d'adhésion mis en oeuvre à l'étape (i) ;
iii) exposition de ladite zone sélectionnée à un rayonnement lumineux dont l'énergie est au moins égale à celle du gap dudit semi-conducteur.

2. Procédé de préparation selon la revendication 1, **caractérisé en ce que** ledit substrat semi-conducteur photosensible est choisi dans le groupe constitué par les éléments du groupe IV ; les alliages d'éléments du groupe IV ; les alliages d'éléments du groupe III et du groupe V et les alliages d'éléments du groupe II et du groupe VI.

3. Procédé de préparation selon l'une quelconque des revendications précédentes, **caractérisé en ce que** ledit substrat semi-conducteur photosensible est placé au contact et peut être en partie recouvert avec un matériau conducteur, la partie recouverte par ledit matériau conducteur étant avantageusement située sur la face arrière dudit substrat semi-conducteur photosensible.

4. Procédé de préparation selon l'une quelconque des revendications précédentes, **caractérisé en ce que** ledit primaire d'adhésion est un sel d'aryle clivable choisi dans le groupe constitué par les sels d'aryle diazonium, les sels d'aryle d'ammonium, les sels d'aryle phosphonium et les sels d'aryle sulfonium.

5. Procédé de préparation selon l'une quelconque des revendications 1 à 3, **caractérisé en ce que** ledit primaire d'adhésion est un sel d'aryle clivable de formule (I) suivante :
R-N₂⁺, A⁻ (I)
dans laquelle :
- A représente un anion monovalent avantageusement choisi parmi les anions inorganiques, les halogénoborates et les anions organiques et
- R représente un groupe aryle, avantageusement, choisi parmi les structures carbonées aromatiques ou hétéroaromatiques, éventuellement mono- ou polysubstituées, constituées d'un ou plusieurs cycles aromatiques ou hétéroaromatiques comportant chacun de 3 à 8 atomes, le ou les hétéroatomes pouvant être N, O, P ou S, le ou les substituants pouvant contenir un ou plusieurs hétéroatomes ou des groupes alkyles en C₁ à C₆.

6. Procédé de préparation selon la revendication 5, **caractérisé en ce que** le composé de formule (I) est choisi dans le groupe constitué par le tétrafluoroborate de phényldiazonium, le tétrafluoroborate de 4-nitrophényldiazonium, le tétrafluoroborate de 4-bromophényldiazonium, le chlorure de 4-aminophényldiazonium, le chlorure de 2-méthyl-4-chlorophényldiazonium, le tétrafluoroborate de 4-benzoylbenzènediazonium, le tétrafluoroborate de 4-cyanophényldiazonium, le tétrafluoroborate du 4-carboxyphényldiazonium, le tétrafluoroborate de 4-acétamidophényldiazonium, le tétrafluoroborate de l'acide 4-phénylacétique diazonium, le sulfate de 2-méthyl-4-[(2-méthylphényl)diazényl]benzènediazonium, le chlorure de 9,10-dioxo-9,10-dihydro-1-anthracènediazonium, le tétrafluoroborate de 4-nitronaphtalènediazonium et le tétrafluoroborate de naphtalènediazonium.

7. Procédé de préparation selon l'une quelconque des revendications précédentes, **caractérisé en ce que** ledit primaire d'adhésion est soit introduit en l'état dans ladite solution liquide, soit être préparé *in situ* dans cette dernière.

8. Procédé de préparation selon l'une quelconque des revendications précédentes, **caractérisé en ce que** ladite solution liquide contient en outre au moins un monomère polymérisable par voie radicalaire différent dudit primaire d'adhésion, ledit monomère étant avantageusement une molécule comportant au moins une liaison de type éthylénique.

9. Procédé de préparation selon la revendication 8, **caractérisé en ce que** ledit monomère polymérisable par voie radicalaire est un monomère de formule (II) suivante : 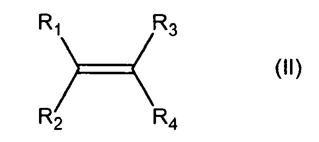 dans laquelle les groupes R₁ à R₄, identiques ou différents, représentent un atome monovalent non métallique tel qu'un atome d'halogène, un atome d'hydrogène, un groupe chimique saturé ou insaturé, tel qu'un groupe alkyle, aryle, un groupe -COOR₅ dans lequel R₅ représente un atome d'hydrogène ou un groupe alkyle en C₁-C₁₂ et de préférence en C₁-C₆, un nitrile, un carbonyle, une amine ou un amide,
ledit monomère polymérisable par voie radicalaire étant avantageusement choisi dans le groupe constitué par l'acétate de vinyle, l'acrylonitrile, le méthacrylonitrile, le méthacrylate de méthyle, le méthacrylate d'éthyle, le méthacrylate de butyle, le méthacrylate de propyle, le méthacrylate d'hydroxyéthyle, le méthacrylate d'hydroxypropyle, le méthacrylate de glycidyle et leurs dérivés ; les acrylamides et notamment les méthacrylamides d'amino-éthyle, propyle, butyle, pentyle et hexyle, les cyanoacrylates, les di-acrylates et di-méthacrylates, les tri-acrylates et tri-méthacrylates, les tétra-acrylates et tétra-méthacrylates (tels que le pentaérythritol tetraméthacrylate), le styrène et ses dérivés, le parachloro-styrène, le pentafluoro-styrène, la N-vinyl pyrrolidone, la 4-vinyl pyridine, la 2-vinyl pyridine, les halogénures de vinyle, d'acryloyle ou de méthacryloyle, le di-vinylbenzène (DVB), et plus généralement les agents réticulants vinyliques ou à base d'acrylate, de méthacrylate, et de leurs dérivés.

10. Procédé de préparation selon la revendication 8 ou 9, **caractérisé en ce que** ledit procédé comprend une étape préalable durant laquelle ledit monomère polymérisable est dispersé ou émulsionné en présence d'au moins un tensioactif ou par action des ultrasons, avant son mélange à la solution liquide comprenant au moins un primaire d'adhésion.

11. Procédé de préparation selon l'une quelconque des revendications précédentes, **caractérisé en ce que** ladite solution liquide contient en outre un solvant tel qu'un solvant protique avantageusement choisi dans le groupe constitué par l'eau, l'acide acétique, les solvants hydroxylés comme le méthanol et l'éthanol, les glycols liquides de faible poids moléculaire tels que l'éthylèneglycol, et leurs mélanges.

12. Procédé de préparation selon l'une quelconque des revendications précédentes, **caractérisé en ce que** ledit potentiel électrique à l'étape (ii) est proche du potentiel de réduction dudit primaire d'adhésion.

13. Procédé de préparation selon l'une quelconque des revendications précédentes, **caractérisé en ce que** ledit potentiel électrique à l'étape (ii) est jusqu'à 50% plus élevée que le potentiel de réduction du primaire d'adhésion.

14. Procédé de préparation selon l'une quelconque des revendications précédentes, **caractérisé en ce que** ladite polarisation de l'étape (ii) est effectuée en conditions de voltampérométrie cyclique, le nombre de cycles étant avantageusement compris entre 1 et 10 et/ou le domaine de potentiel balayé étant avantageusement compris entre le potentiel d'équilibre de la solution liquide telle que définie à l'une quelconque des revendications 1, 8 ou 11, et entre une valeur supérieure au maximum à 50% de la valeur du potentiel de réduction du primaire d'adhésion.

15. Procédé de préparation selon l'une quelconque des revendications précédentes, **caractérisé en ce que** ledit rayonnement lumineux à l'étape (iii) est focalisé sur ladite zone sélectionnée.

16. Procédé de préparation selon l'une quelconque des revendications précédentes, **caractérisé en ce que** ledit rayonnement lumineux à l'étape (iii) est monochromatique filtré ou polychromatique filtré.

17. Procédé de préparation selon l'une quelconque des revendications précédentes, **caractérisé en ce que** l'intensité dudit rayonnement lumineux à l'étape (iii) est au moins égale à 2 mW.cm⁻² et n'est pas supérieure à 45 mW.cm⁻².

18. Procédé de préparation selon l'une quelconque des revendications précédentes, **caractérisé en ce qu'**un masque imperméable au rayonnement employé est utilisé à l'étape (iii) en regard de ladite surface du substrat ou à proximité de celle-ci.

## Claims

1. Process for preparing an organic film on a selected zone at the surface of a photosensitive semiconductor substrate optionally doped by one (or more) dopant(s), **characterized in that** it comprises the following steps:
i) bringing a liquid solution comprising at least one organic adhesion primer into contact with at least said selected zone;
ii) polarization of the surface of said substrate to an electric potential more cathodic than the reduction potential of the adhesion primer used in step (i); and
iii) exposure of said selected zone to light radiation, the energy of which is at least equal to that of the band gap of said semiconductor.

2. Preparation process according to Claim 1, **characterized in that** said photosensitive semiconductor substrate is chosen from the group constituted by the elements from group IV; the alloys of elements from group IV; the alloys of elements from group III and from group V and the alloys of elements from group II and from group VI.

3. Preparation process according to any one of the preceding claims, **characterized in that** said photosensitive semiconductor substrate is placed in contact with and may be partly covered by a conductive material, the portion covered by said conductive material being advantageously located on the rear face of said photosensitive semiconductor substrate.

4. Preparation process according to any one of the preceding claims, **characterized in that** said adhesion primer is a cleavable aryl salt chosen from the group constituted by aryldiazonium salts, arylammonium salts, arylphosphonium salts and arylsulphonium salts.

5. Preparation process according to any one of Claims 1 to 3, **characterized in that** said adhesion primer is a cleavable aryl salt of formula (I) below:
R-N₂⁺, A⁻ (I)
in which:
- A represents a monovalent anion advantageously chosen from inorganic anions, haloborates and organic anions ; and
- R represents an aryl group, advantageously chosen from the optionally monosubstituted or polysubstituted, aromatic or heteroaromatic carbon-based structures constituted of one or more aromatic or heteroaromatic rings each comprising from 3 to 8 atoms, the heteroatom(s) possibly being N, O, P or S, the substituent(s) possibly containing one or more heteroatoms or C₁ to C₆ alkyl groups.

6. Preparation process according to Claim 5, **characterized in that** the compound of formula (I) is chosen from the group constituted by phenyldiazonium tetrafluoroborate, 4-nitrophenyldiazonium tetrafluoroborate, 4-bromophenyldiazonium tetrafluoroborate, 4-aminophenyldiazonium chloride, 2-methyl-4-chlorophenyldiazonium chloride, 4-benzoylbenzenediazonium tetrafluoroborate, 4-cyano-phenyldiazonium tetrafluoroborate, 4-carboxyphenyl-diazonium tetrafluoroborate, 4-acetamidophenyldiazonium tetrafluoroborate, 4-phenylacetic acid diazonium tetrafluoroborate, 2-methyl-4-[(2-methylphenyl)-diazenyl]benzenediazonium sulphate, 9,10-dioxo-9,10-dihydro-1-anthracenediazonium chloride, 4-nitro-naphthalenediazonium tetrafluoroborate and naphthalenediazonium tetrafluoroborate.

7. Preparation process according to any one of the preceding claims, **characterized in that** said adhesion primer is either introduced as is into said liquid solution, or is prepared *in situ* in the latter.

8. Preparation process according to any one of the preceding claims, **characterized in that** said liquid solution also contains at least one radically-polymerisable monomer different from said adhesion primer, said monomer being advantageously a molecule comprising at least one ethylenic-type bond.

9. Preparation process according to Claim 8, **characterized in that** said radically-polymerisable monomer is a monomer of formula (II) below: 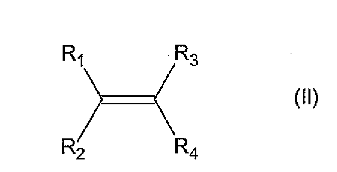 in which the R₁ to R₄ groups, which are identical or different, represent a non-metallic monovalent atom such as a halogen atom, a hydrogen atom, a saturated or unsaturated chemical group, such as an alkyl or aryl group, a -COOR₅ group in which R₅ represents a hydrogen atom or a C₁-C₁₂, preferably C₁-C₆, alkyl group, a nitride, a carbonyl, an amine or an amide, said radically polymerisable monomer being advantageously chosen from the group constituted by vinyl acetate, acrylonitrile, methacrylonitrile, methyl methacrylate, ethyl methacrylate, butyl methacrylate, propyl methacrylate, hydroxyethyl methacrylate, hydroxypropyl methacrylate, glycidyl methacrylate and derivatives thereof; acrylamides and especially aminoethyl, propyl, butyl, pentyl and hexyl methacrylamides, cyanoacrylates, diacrylates and dimethacrylates, triacrylates and trimethacrylates, tetraacrylates and tetramethacrylates (such as pentaerythritol tetramethacrylate), styrene and its derivatives, parachlorostyrene, pentafluorostyrene, N-vinylpyrrolidone, 4-vinylpyridine, 2-vinylpyridine, vinyl, acryloyl or methacryloyl halides, divinylbenzene (DVB), and more generally vinyl crosslinking agents or crosslinking agents based on acrylate, methacrylate, and derivatives thereof.

10. Preparation process according to Claim 8 or 9, **characterized in that** said process comprises a prior step during which said polymerisable monomer is dispersed or emulsified in the presence of at least one surfactant or by ultrasound, before it is mixed with the liquid solution comprising at least one adhesion primer.

11. Preparation process according to any one of the preceding claims, **characterized in that** said liquid solution also contains a solvent such as a protic solvent advantageously chosen from the group constituted by water, acetic acid, hydroxylated solvents such as methanol and ethanol, liquid glycols of low molecular weight such as ethylene glycol, and mixtures thereof.

12. Preparation process according to any one of the preceding claims, **characterized in that** said electric potential in step (ii) is close to the reduction potential of said adhesion primer.

13. Preparation process according to any one of the preceding claims, **characterized in that** said electric potential in step (ii) is up to 50% higher than the reduction potential of the adhesion primer.

14. Preparation process according to any one of the preceding claims, **characterized in that** said polarization of step (ii) is carried out under cyclic voltammetry conditions, the number of cycles being advantageously between 1 and 10 and/or the range of potential scanned being advantageously between the equilibrium potential of the liquid solution as defined in any one of Claims 1, 8 or 11 and between a value at most 50% greater than the value of the reduction potential of the adhesion primer.

15. Preparation process according to any one of the preceding claims, **characterized in that** said light radiation in step (iii) is focused on said selected zone.

16. Preparation process according to any one of the preceding claims, **characterized in that** said light radiation in step (iii) is filtered monochromatic or filtered polychromatic light radiation.

17. Preparation process according to any one of the preceding claims, **characterized in that** the intensity of said light radiation in step (iii) is at least equal to 2 mW.cm⁻² and is not greater than 45 mW.cm⁻².

18. Preparation process according to any one of the preceding claims, **characterized in that** a mask impermeable to the radiation employed is used in step (iii) opposite said substrate surface or in the vicinity of the latter.

## Patentansprüche

1. Verfahren zur Herstellung eines organischen Films auf einer ausgewählten Zone auf der Oberfläche eines gegebenenfalls mit einem (oder mehreren) Dotierungsmittel(n) dotierten, lichtempfindlichen Halbleitersubstrats, **dadurch gekennzeichnet, dass** es die folgenden Schritte umfasst:
i) In-Kontakt-Bringen einer wenigstens einen organischen Haftgrund umfassenden flüssigen Lösung mit mindestens der ausgewählten Zone,
ii) Polarisation der Substratoberfläche auf ein kathodischeres elektrisches Potential als das Reduktionspotential des in Schritt (i) eingesetzten Haftgrunds,
ii) Aussetzen der ausgewählten Zone einer Lichtstrahlung, deren Energie mindestens gleich der der Lücke des Halbleiters ist.

2. Herstellungsverfahren gemäß Anspruch 1, **dadurch gekennzeichnet, dass** das lichtempfindliche Halbleitersubstrat aus der Gruppe ausgewählt ist, die sich aus den Elementen der Gruppe IV, den Legierungen der Elemente der Gruppe IV, den Legierungen der Elemente der Gruppe III und der Gruppe V und den Legierungen der Elemente der Gruppe II und der Gruppe VI zusammensetzt.

3. Herstellungsverfahren gemäß einem der vorangehenden Ansprüche, **dadurch gekennzeichnet, dass** das lichtempfindliche Halbleitersubstrat mit einem Leitermaterial in Kontakt gebracht und möglicherweise zum Teil damit überzogen wird, wobei sich der mit dem Leitermaterial überzogene Teil vorteilhafterweise auf der Hinterseite des lichtempfindlichen Halbleitersubstrats befindet.

4. Herstellungsverfahren gemäß einem der vorangehenden Ansprüche, **dadurch gekennzeichnet, dass** der Haftgrund ein spaltbares Arylsalz ist, das aus der sich aus Aryldiazoniumsalzen, Arylammoniumsalzen, Arylphosphoniumsalzen und Arylsulfoniumsalzen zusammensetzenden Gruppe ausgewählt ist.

5. Herstellungsverfahren gemäß einem der Ansprüche 1 bis 3, **dadurch gekennzeichnet, dass** der Haftgrund ein spaltbares Arylsalz der folgenden Formel (I) ist:
R-N₂⁺, A⁻ (I),
worin:
- A ein einwertiges Anion darstellt, das vorteilhafterweise aus anorganischen Anionen, Halogenboraten und organischen Anionen ausgewählt ist, und
- R eine Arylgruppe darstellt, die vorteilhafterweise aus aromatischen oder heteroaromatischen kohlenstoffhaltigen Strukturen ausgewählt ist, die gegebenenfalls ein- oder mehrfach substituiert sind und sich aus einem oder mehreren aromatischen oder heteroaromatischen Cyclen zusammensetzen, die jeweils 3 bis 8 Atome umfassen, wobei das oder die Heteroatome N, O, P oder S sein können, und der oder die Substituenten ein oder mehrere Heteroatome oder C₁-C₆-Alkylgruppen enthalten können.

6. Herstellungsverfahren gemäß Anspruch 5, **dadurch gekennzeichnet, dass** die Verbindung der Formel (I) aus der Gruppe ausgewählt ist, die sich aus Phenyldiazoniumtetrafluorborat, 4-Nitrophenyldiazoniumtetrafluorborat, 4-Bromphenyldiazoniumtetrafluorborat, 4-Aminophenyldiazoniumchlorid, 2-Methyl-4-chlorphenyldiazoniumchlorid, 4-Benzoylbenzoldiazoniumtetafluorborat, 4-Cyanphenyldiazoniumtetrafluorborat, 4-Carboxyphenyldiazoniumtetrafluorborat, 4-Acetamidophenyldiazoniumtetrafluorborat, 4-Phenylessigsäurediazoniumtetrafluorborat, 2-Methyl-4-[(2-methylphenyl)diazenyl]benzoldiazoniumsulfat, 9,10-Dioxo-9,10-dihydro-1-anthracendiazoniumchlorid, 4-Nitronaphthalindiazoniumtetrafluorborat und Naphthalindiazoniumtetrafluorborat zusammensetzt.

7. Herstellungsverfahren gemäß einem der vorangehenden Ansprüche, **dadurch gekennzeichnet, dass** der Haftgrund entweder als solcher der flüssigen Lösung zugeführt wird oder darin in situ hergestellt wird.

8. Herstellungsverfahren gemäß einem der vorangehenden Ansprüche, **dadurch gekennzeichnet, dass** die flüssige Lösung außerdem wenigsten ein Monomer enthält, das von dem Haftgrund verschieden und radikalisch polymerisierbar ist, wobei das Monomer vorteilhafterweise ein Molekül ist, das wenigstens eine Bindung des Ethylentyps aufweist.

9. Herstellungsverfahren gemäß Anspruch 8, **dadurch gekennzeichnet, dass** das radikalisch polymerisierbare Monomer ein Monomer der folgenden Formel (II) ist: 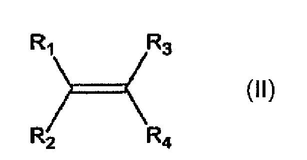 worin die Gruppen R₁ bis R₄ gleich oder verschieden sind und ein einwertiges Nichtmetallatom wie etwa ein Halogenatom, ein Wasserstoffatom, eine gesättigte oder ungesättigte chemische Gruppe wie etwa eine Alkyl- oder Arylgruppe, eine Gruppe -COOR₅, worin R₅ ein Wasserstoffatom oder eine C₁-C₁₂-, vorzugsweise C₁-C₆-Alkylgruppe darstellt, eine Nitrilgruppe, eine Carbonylgruppe, ein Amin oder Amid darstellen,
wobei das radikalisch polymerisierbare Monomer vorteilhafterweise aus der Gruppe ausgewählt ist, die sich aus Vinylacetat, Acrylnitril, Methacrylnitril, Methylmethacrylat, Ethylmethacrylat, Butylmethacrylat, Propylmethacrylat, Hydroxyethylmethacrylat, Hydroxypropylmethacrylat und Glycidylacrylat und ihren Derivaten, Acrylamiden und insbesondere Aminoethyl-, Propyl-, Butyl-, Pentyl- und Hexylmethacrylamid, Cyanacrylaten, Diacrylaten und Dimethacrylaten, Triacrylaten und Trimethacrylaten, Tetraacrylaten und Tetramethacrylaten (wie etwa Pentaerythrit-tetramethacrylat), Styrol und seinen Derivaten, p-Chlorstyrol, Pentafluorstyrol, N-Vinylpyrrolidon, 4-Vinylpyridin, 2-Vinylpyridin, Vinyl-, Acryloyl- oder Methacryloylhalogeniden, Divinylbenzol (DVB) und allgemeiner vinylischen Vernetzungsmitteln oder solchen auf Acrylat- oder Methacrylatgrundlage und ihren Derivaten zusammensetzt.

10. Herstellungsverfahren gemäß Anspruch 8 oder 9, **dadurch gekennzeichnet, dass** das Verfahren einen vorherigen Schritt umfasst, währen dessen das polymerisierbare Monomer in Gegenwart wenigstens eines Tensids oder durch Ultraschalleinwirkung vor seinem Mischen mit der wenigstens einen Haftgrund umfassenden flüssigen Lösung dispergiert oder emulgiert wird.

11. Herstellungsverfahren gemäß einem der vorangehenden Ansprüche, **dadurch gekennzeichnet, dass** die flüssige Lösung außerdem ein Lösungsmittel wie etwa ein protisches Lösungsmittel enthält, das vorteilhafterweise aus der Gruppe ausgewählt ist, die sich aus Wasser, Essigsäure, hydroxylierten Lösungsmitteln wie etwa Methanol und Ethanol, flüssigen Glykolen niedrigen Molekulargewichts wie etwa Ethylenglykol und ihren Gemischen zusammensetzt.

12. Herstellungsverfahren gemäß einem der vorangehenden Ansprüche, **dadurch gekennzeichnet, dass** das elektrische Potential in Schritt (ii) in der Nähe des Reduktionspotentials des Haftgrunds liegt.

13. Herstellungsverfahren gemäß einem der vorangehenden Ansprüche, **dadurch gekennzeichnet, dass** das elektrische Potential in Schritt (ii) bis zu 50 % höher als das Reduktionspotential des Haftgrunds ist.

14. Herstellungsverfahren gemäß einem der vorangehenden Ansprüche, **dadurch gekennzeichnet, dass** die Polarisation des Schritts (ii) unter Bedingungen der cyclischen Voltammetrie erzeugt wird, wobei die Anzahl der Cyclen vorteilhafterweise zwischen 1 und 10 beträgt und/oder der Bereich des überstrichenen Potentials vorteilhafterweise zwischen dem Gleichgewichtspotential der in einem der Ansprüche 3, 8 oder 11 definierten flüssigen Lösung und zwischen einem Wert höchstens 50 % über dem Wert des Reduktionspotentials des Haftgrunds beträgt.

15. Herstellungsverfahren gemäß einem der vorangehenden Ansprüche, **dadurch gekennzeichnet, dass** die Lichtstrahlung in Schritt (iii) auf die ausgewählte Zone fokussiert wird.

16. Herstellungsverfahren gemäß einem der vorangehenden Ansprüche, **dadurch gekennzeichnet, dass** die Lichtstrahlung in Schritt (iii) monochromatisch gefiltert oder polychromatisch gefiltert ist.

17. Herstellungsverfahren gemäß einem der vorangehenden Ansprüche, **dadurch gekennzeichnet, dass** die Intensität der Lichtstrahlung in Schritt (iii) mindestens 2 mW.cm⁻² und nicht über 45 mW.cm⁻² beträgt.

18. Herstellungsverfahren gemäß einem der vorangehenden Ansprüche, **dadurch gekennzeichnet, dass** in Schritt (iii) der Substratoberfläche gegenüberliegend oder in deren Nähe eine für die eingesetzte Strahlung undurchlässige Maske verwendet wird.
